# EUROPEAN PATENT SPECIFICATION

(11) **EP 3 180 410 B1**
(45) Date of publication and mention of the grant of the patent: **24.06.2020**
(21) Application number: 15753650.9
(22) Date of filing: 07.08.2015
(51) Int. Cl.: C09K 11/02, C09K 11/62, C09K 11/88

(54) **ELECTROLUMINESCENT CROSSLINKED NANOCRYSTAL FILMS**
ELEKTROLUMINESZENTE VERNETZTE NANOKRISTALLINE FILME
FILMS NANOCRISTALLINS RÉTICULÉS ÉLECTROLUMINESCENTS

(30) Priority: 11.08.2014 EP 14180542
(43) Date of publication of application: 21.06.2017
(73) Proprietor: Suzhou Rainbow Materials Co., Ltd., Zhangjiagang Jiangsu 215634 (CN)
(72) Inventor: TORRES CANO, Elisabet, 08022 Barcelona (ES); SALHI, Fouad, 08193 Barcelona (ES); MINNAAR, Jozeph Leendert, 4328 PB Zeeland (NL); ALMARZA MARTINEZ, Albert, 08027 Barcelona (ES); MORELL BEL, Mireia, 17190 Salt (ES); CARRERAS, Paz, 08029 Barcelona (ES)
(74) Representative: Baudler, Ron
(86) International application number: PCT/EP2015/068232
(87) International publication number: WO 2016/023819

(56) References cited:
- WO-A1-2013/057702
- US-A1- 2008 231 170
- US-A1- 2010 006 775
- MA XIN ET AL: "High performance hybrid near-infrared LEDs using benzenedithiol cross-linked PbS colloidal nanocrystals", ORGANIC ELECTRONICS, ELSEVIER, AMSTERDAM, NL, vol. 13, no. 3, 2 January 2012 (2012-01-02), pages 525-531, XP028856817, ISSN: 1566-1199, DOI: 10.1016/J.ORGEL.2011.12.012

## Description

### Technical field

The present invention relates to an emissive film comprising a network of crosslinked nanocrystals, wherein said network of crosslinked nanocrystals is formed from reactive colloidal nanocrystals comprising a core comprising a semiconductive compound and at least one polythiol ligand. Furthermore, the present invention encompasses, a nanocrystal light emitting device comprising a multilayer structure comprising an emissive film layer according to present invention.

### Background of the invention

A nanocrystal light emitting device (NC-LED) is a light emitting device in which the emissive layer contains nanocrystals. When NC-LEDs are fabricated, the emissive layer are conventionally 1) composed from organic emitting polymers and nanocrystals (NC) or 2) composed from monolayers of nanocrystals. In the first approach, only very low efficiencies have been achieved because of an inefficient exciton formation in the NCs. Instead, the use of monolayers of NCs in the second approach led to record efficiencies due to an improved confinement of the electrons and minimized electrical resistance.

Conventional NCs are typically stabilized by monofunctional non-reactive ligands that make the NCs hydrophobic and passive. Thus, when a layer is formed, the NCs cannot be chemically linked to each other, only stabilized close to each other by entanglement between the ligands.

When NC-LEDs are fabricated, the NC film is sandwiched between layered structures. Using conventional monolayers of NCs as an emissive layer of NC-LEDs, further solvent processing of the following layers is not recommended since it can dissolve or degrade the underlying NC layer.

In addition, due to their size and in some cases, due to their composition, NCs are toxic to environment and human health by inhalation or skin absorption. Traditionally, NCs forming a monolayer are easily spread into the atmosphere, and therefore become a hazard for the manufacturer.

In some cases, the NCs are crosslinked between each other in a two-step process. In the first step, a monolayer of NCs capped with conventional monofunctional ligands is deposited. In the second step, the film is dipped in a linker solution in order to perform a ligand exchange with pre-existing monofunctional ligands. However, ligand exchange procedures degrade the quality of the NCs by increasing the number of surface defects. It also implies more steps during the deposition process of NC-LEDs. Moreover, the underlying layers are exposed to a linker solution that can further degrade them.

Ma Xin et. al. in their paper in Organic Electronics (Vol. 13, No. 3, pages 525-531) disclose an all solution-based processing method to produce efficient hybrid polymer-nanocrystal multilayered hetero structures for electroluminescence in the near-infrared (1050-1600 nm). US 2010/006775 discloses a solid-state lamp comprising: a light emitting diode providing an ultraviolet light output; a quantum dot phosphor receiving the ultraviolet light to emit a white light, the quantum dot phosphor comprising: (a) a quantum dot; (b) a capping layer surrounding the quantum dot; and (c) an activator material attached to the capping layer to be spaced from the quantum dot by the capping layer so as to promote phosphorescence with the quantum dot.

Therefore, there is need for an emissive film, which is high loaded and NCs are well-dispersed displaying high and stable luminescent properties, while being safer for human health and environment.

### Short description of the figures

Figure 1 illustrates the structure of NC according to the present invention.
Figure 2 illustrates the structure of the crosslinked NC structure according to the present invention.
Figure 3 illustrates schematic structure of nanocrystal light emitting device according to one embodiment of the invention.
Figure 4 illustrates schematic structure of nanocrystal light emitting device according to one embodiment of the invention.

### Summary of the invention

The present invention relates to an emissive film comprising a network of crosslinked nanocrystals, wherein said network of crosslinked nanocrystals is formed from reactive colloidal nanocrystals comprising a) a core comprising a semiconductive compound, wherein said semiconductive compound is a combination of elements selected from the group consisting of Zn, In, Cu, S and Se; and b) at least one polythiol ligand selected from the group consisting of primary thiols, secondary thiols and mixtures thereof, and wherein said core is surrounded by at least one polythiol ligand, wherein each core surrounded by at least one polythiol ligand is crosslinked with at least one another polythiol ligand surrounding another core, and wherein said ligands do not undergo a ligand exchange process and only the original ligands present during synthesis are attached.

In addition, the present invention relates to a process to prepare an emissive film according to the present invention comprising steps of 1) mixing a core comprising semiconductive compound and at least one polythiol ligand to form a reactive colloidal nanocrystal; 2) optionally adding at least one solvent into a product of step 1; 3) forming a film from the mixture of step 2; and 4) optionally thermal curing.

Furthermore, the present invention encompasses, a nanocrystal light emitting device comprising a multilayer structure comprising an emissive film layer according to present invention, a cathode layer and an anode layer.

### Detailed description of the invention

In the following passages the present invention is described in more detail. Each aspect so described may be combined with any other aspect or aspects unless clearly indicated to the contrary. In particular, any feature indicated as being preferred or advantageous may be combined with any other feature or features indicated as being preferred or advantageous. In the context of the present invention, the terms used are to be construed in accordance with the following definitions, unless a context dictates otherwise.

As used herein, the singular forms "a", "an" and "the" include both singular and plural referents unless the context clearly dictates otherwise.

The terms "comprising", "comprises" and "comprised of" as used herein are synonymous with "including", "includes" or "containing", "contains", and are inclusive or open-ended and do not exclude additional, non-recited members, elements or method steps.

The recitation of numerical end points includes all numbers and fractions subsumed within the respective ranges, as well as the recited end points.

All percentages, parts, proportions and the like mentioned herein are based on weight unless otherwise indicated.

When an amount, a concentration or other values or parameters is/are expressed in form of a range, a preferable range, or a preferable upper limit value and a preferable lower limit value, it should be understood as that any ranges obtained by combining any upper limit or preferable value with any lower limit or preferable value are specifically disclosed, without considering whether the obtained ranges are clearly mentioned in the context.

Unless otherwise defined, all terms used in the disclosing the invention, including technical and scientific terms, have the meaning as commonly understood by one of the ordinary skill in the art to which this invention belongs to. By means of further guidance, term definitions are included to better appreciate the teaching of the present invention.

The present invention relates to the emissive film comprising a network of crosslinked nanocrystals, wherein said network of crosslinked nanocrystals is formed from reactive colloidal nanocrystals comprising a core comprising a semiconductive compound and at least one polythiol ligand, and wherein said core is surrounded by at least one polythiol ligand, and wherein each core surrounded by at least one polythiol ligand is crosslinked with at least one another polythiol ligand surrounding another core.

The present invention relates to a simple method to obtain self-crosslinked NC films. The films prepared according to the present invention can be used as the emissive layer of NC-LEDs. Following this procedure, the solution processability and toxicity issues that concern the use of the conventional methods relating to NCs are overcome.

By the term 'nanocrystal' is meant a nanometer-scale crystalline particle, which can comprise a core/shell structure and wherein a core comprises a first material and a shell comprises a second material, and wherein the shell is disposed over at least a portion of a surface of the core.

By the term 'ligand' is meant molecules having one or more chains that are used to stabilize nanocrystals. Ligands have at least one focal point where it binds to the nanocrystal, and at least one active site that either interacts with the surrounding environment, crosslinks with other active sites or both.

By the term 'reactive colloidal nanocrystals' is meant reactive colloidal nanocrystals, which are solution-grown, nanometer-sized, inorganic particles that are stabilized by a layer of ligands that contain at least one functional group in the backbone that can be reacted preferably into a composite structure.

The NCs described in the present invention do not undergo a ligand exchange process, which has been widely used in the prior art. Therefore, only the original ligands present during the synthesis are attached to the NCs. In contrast, NCs that undergo a ligand exchange process, have at least two type of ligands, the ligand attached during the synthesis and the ligand added during the ligand exchange. Studies have shown that after a ligand exchange process, part of the original ligand is still attached to the NC surface, see for example the paper of Knittel *et.al.* (Knittel, F. et al. On the Characterization of the Surface Chemistry of Quantum Dots. Nano Lett. 13, 5075-5078 (2013)).

By the term 'NC film' is meant a continuous layer of crosslinked nanocrystals. Crosslinking is formed preferably via covalent bonds.

Each of the essential components of the emissive film will be discussed in detail.

An emissive film according to the present invention comprises a network of crosslinked nanocrystals, wherein said network of crosslinked nanocrystals is formed from reactive colloidal nanocrystals comprising a) a core comprising a semiconductive compound, wherein said semiconductive compound is a combination of elements selected from the group consisting of Zn, In, Cu, S and Se; and b) at least one polythiol ligand selected from the group consisting of primary thiols, secondary thiols and mixtures thereof, and wherein said core is surrounded by at least one polythiol ligand, wherein each core surrounded by at least one polythiol ligand is crosslinked with at least one another polythiol ligand surrounding another core, and wherein said ligands do not undergo a ligand exchange process and only the original ligands present during synthesis are attached.

### Reactive colloidal nanocrystal

Reactive colloidal nanocrystals according to the present invention comprise a core comprising a semiconductive compound and at least one polythiol ligand.

### Core comprising a semiconductive compound

Core of the reactive colloidal nanocrystal according to present invention comprises semiconductive compound. A semiconductive compound is composed of elements from one or more different groups of the periodic table.

The semiconductive compound is combination of one or more selected from the group consisting of Zn, In, Cu, S and Se.

Optionally, the core comprising the semiconductive compound may further comprise a dopant. Suitable examples of dopants to be used in the present invention are selected from the group consisting of Mn, Ag, Zn, Eu, S, P, Cu, Ce, Tb, Au, Pb, Sb, Sn, TI and mixtures thereof.

In one preferred embodiment, the core comprising a semiconductive compound is core comprising copper in combination with one or more compound selected from the group I and/or group II and/or group III and/or group IV and/or group V and/or group VI.

In another preferred embodiment the core comprising copper is selected from the group consisting of CuInS, CuInSeS, CuZnInSeS, CuZnInS, Cu:ZnInS, CuInS/ZnS, Cu:ZnInS/ZnS, CuInSeS/ZnS, preferably selected from the group consisting of CuInS/ZnS, CuInSeS/ZnS, Cu:ZnlnS/ZnS.

The core of the nanocrystals according to the present invention has a structure including the core alone or the core and one or more shell(s) surrounding the core. Each shell may have structure comprising one or more layers, meaning that each shell may have monolayer or multilayer structure. Each layer may have a single composition or an alloy or concentration gradient.

In one embodiment, the core of the nanocrystal according to the present invention has a structure comprising a core and at least one monolayer or multilayer shell. Yet, in another embodiment, the core of the nanocrystal according to the present invention has a structure comprising a core and at least two monolayer and/or multilayer shells.

In one embodiment, the core of the nanocrystal according to the present invention has a structure comprising a core comprising copper and at least one monolayer or multilayer shell. Yet, in another embodiment, the core of the nanocrystal according to the present invention has a structure comprising a core comprising copper and at least two monolayer and/or multilayer shells.

Preferably, the size of the core of the reactive colloidal nanocrystals according to the present invention is less than 100 nm, more preferably less than 50, more preferably less than 10, however, preferably the core is larger than 1 nm.

Preferably, the shape of the core of the reactive colloidal nanocrystal according to the present invention is spherical, rod or triangle shape.

### Polythiol ligand

A reactive colloidal nanocrystal according to present invention comprises at least one polythiol ligand.

By the term polythiol is meant herein ligands having multiple thiol groups in the molecular structure. Furthermore, said polythiols used in the present invention have multiple functions (to act as a precursor, solvent and stabilizer), and therefore, can be considered as multifunctional polythiols. In other words the polythiol ligands used in the present invention are used as multifunctional reagents.

A polythiol ligand suitable to be used in the present invention has functionality from 2 or more, preferably from 3 to 4. Meaning that the polythiol ligand has at least 2 thiol groups in the structure, preferably from 3 to 4.

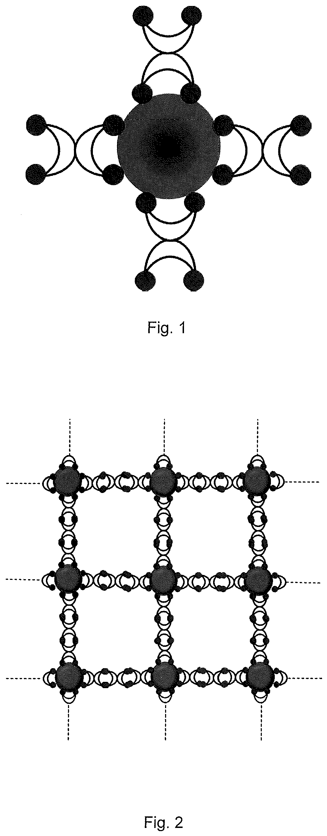

A reactive colloidal nanocrystal according to the present invention have a structure wherein the core is surrounded by at least one polythiol ligand. Figure 1 illustrates this structure in general level. And wherein each core surrounded by at least one polythiol ligand is crosslinked with at least one another polythiol ligand surrounding another core, and wherein said ligands do not undergo a ligand exchange process and only the original ligands present during synthesis are attached.

Suitable polythiol ligand to be used in the present invention is selected from the group consisting of primary thiols, secondary thiols and mixtures thereof. Preferably, polythiol ligand to be used in the present invention is selected from the group consisting pentaerythritol tetrakis (3-mercaptobutylate), pentaerythritol tetra-3-mercaptopropionate, trimethylolpropane tri(3-mercaptopropionate), tris[2-(3-mercaptopropionyloxy)ethyl]isocyanurate, dipentaerythritol hexakis(3-mercaptopropionate), ethoxilated-trimethylolpropan tri-3-mercaptopropionate, mercapto functional methylalkyl silicone polymer and mixtures thereof, preferably selected from the group consisting of tetra functionalized pentaerythritol tetrakis (3-mercaptobutylate), pentaerythritol tetra-3-mercaptopropionate, tris[2-(3-mercaptopropionyloxy)ethyl]isocyanurate and mixtures thereof.

Commercially available polythiol ligand for use in the present invention are for example KarenzMT™ PE1 from Showa Denko, PEMP from SC ORGANIC CHEMICAL CO. and THIOCURE® TEMPIC from BRUNO BOCK.

Preferably, reactive colloidal NCs according to the present invention have a particle diameter (e.g. largest particle diameter) ranging from 1 nm to 100 nm, preferably from 1 nm to 50 nm and more preferably from 1 nm to 10 nm.

Reactive colloidal nanocrystals according to the present invention may comprise organic material and inorganic material in ratio between 2:1 and 75:1. Preferably, reactive colloidal nanocrystal according to the present invention may comprise inorganic material from 1 to 99% by weight based on the total weight of the reactive colloidal nanocrystal. Preferably, reactive colloidal nanocrystal according to the present invention may comprise organic material from 1 to 99% by weight based on the total weight of the reactive colloidal nanocrystal.

The reactive colloidal nanocrystals according to the present invention can be prepared in several ways of mixing all ingredients together.

In one preferred embodiment the preparation of the reactive colloidal nanocrystals comprises following steps 1) mixing semiconductive compound(s) and at least one polythiol ligand to form a reactive colloidal nanocrystal. Reactive colloidal nanocrystals can be further purified by precipitation and dissolving in a solvent. Suitable solvents are for example methanol and chloroform.

### An emissive film

An emissive film according to the present invention comprises a network of crosslinked nanocrystals, wherein said network of crosslinked nanocrystals is formed from reactive colloidal nanocrystals comprising a core and at least one polythiol ligand. Polythiol ligand is used in excess as a solvent during the synthesis. After the synthesis, a colloidal solution is formed consisting of nanocrystals surrounded by polythiol ligands dissolved in an excess of the same polythiol solution. During this process, the polythiol ligands can react with each other forming a network that comprises the nanocrystals surrounded by polythiol ligands crosslinked to another polythiol ligands and the excess of polythiols. In other words, each core is surrounded by at least one polythiol ligand, and in the network of crosslinked nanocrystals each core surrounded by at least one polythiol ligand is crosslinked with at least one another polythiol ligand surrounding another core. Preferably said network of crosslinked nanocrystals is formed via covalent bonds. Figure 2 illustrates this network structure.

An emissive film according to the present invention has a thickness from 2 nm to 2000 nm, preferably from 3 nm to 1000 nm, more preferably from 4 nm to 500 nm, even more preferably from 4 nm to 150 nm and most preferably from 5 nm to 45 nm.

The emissive film according to the present invention can be prepared in several ways of mixing all ingredients together and forming a film.

In one preferred embodiment the preparation of an emissive film according to the present invention comprises steps of:
1) mixing a core comprising semiconductive compound and at least one polythiol ligand to form a reactive colloidal nanocrystal;
2) optionally adding at least one solvent into a product of step 1;
3) forming a film from the mixture of step 2; and
4) optionally thermal curing.

Preferably, the concentration of mixture of step 2 is from 1 mg of reactive colloidal nanocrystals in 1 ml of solvent to 200 mg of reactive colloidal nanocrystals in 1 ml of solvent, preferably from 3 mg of reactive colloidal nanocrystals in 1 ml of solvent to 50 mg of reactive colloidal nanocrystals in 1 ml of solvent and more preferably from 5 mg of reactive colloidal nanocrystals in 1 ml of solvent to 30 mg of reactive colloidal nanocrystals in 1 ml of solvent.

The solvent is used as a carrier in the film forming process, to make the thin film deposition, but not playing any active role in the film formation. The suitable solvent to be used in the present invention can be any organic solvent as long as the organic solvent is capable to disperse the NCs. Preferably, suitable solvent is selected from the group consisting of chloroform, tetrahydrofuran (THF), anisole, toluene, xylene, chlorobenzene, dichlorobenzene, mesitylene, tetralin, cyclohexylbenzene, dimethyl sulfoxide (DMSO), n-methyl-2-pyrrolidone (NMP), dimethylacetamide (DMAc) and mixtures thereof.

Film formation in step 3 can be done by spin coating, drop casting, slot die, dip coating, spray coating, inkjet printing, screen printing, gravure printing, aerosol printing, doctor blade. Preferably the film formation is done by spin coating, drop casting or inkjet printing.

When the film formation is done by spin coating, the spin coating rate is from 100 to 10000 rpm, preferably from 500 to 4000 rpm.

In a preferred embodiment, thermal curing is used as a step 4, the curing temperature is from 25 °C to 250°C, preferably from 100 °C to 180 °C. And thermal curing time is from 0 to 180 minutes, preferably from 10 to 30 minutes.

The formation of the emissive film according to the present invention guarantees that there is no loss in NCs properties when film is formed.

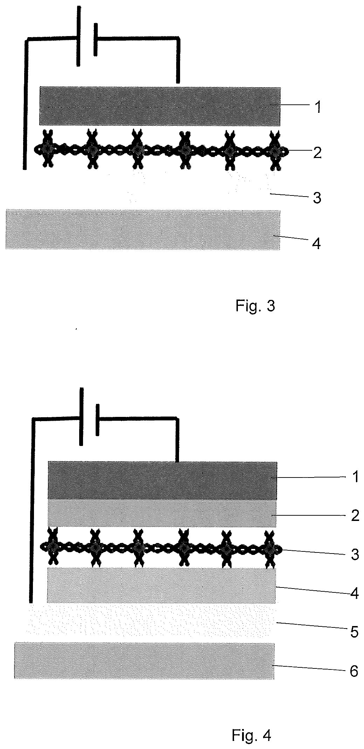

The present invention also encompasses a nanocrystal light emitting device comprising a multilayer structure comprising an emissive film layer according to the present invention, a cathode layer and an anode layer. General structure of the nanocrystal light emitting device according to the present invention is illustrated in figures 3 and 4. In figure 3, the nanocrystal light emitting device having 4 layers is illustrated (1) cathode; (2) NCs film; (3) anode; and (4) substrate. In figure 4, the nanocrystal light emitting device having 6 layers is illustrated (1) cathode; (2) ETL, (3) NCs film; (4) HTL; (5) anode; and (6) substrate.

Electrode layers (cathode and anode layers) are necessary for applying a voltage across the emissive film. Preferable one electrode is transparent and the other electrode is highly reflective. Examples of transparent electrodes are indium tin oxide (ITO) or indium zinc oxide (IZO). Example of opaque electrodes are aluminum or silver.

In one embodiment a nanocrystal light emitting device further comprises a substrate. Any substrate that could withstand the process temperature can be used in the present invention.

Suitable non-limiting examples of substrate to be used in the present invention are glass, Poly(ethylene terephthalate) PET, Poly(methyl methacrylate) (PMMA), Poly(ethylene naphthalate) PEN, poly(imide), polycarbonate (PC), metallic foils, silicon, tiles or textiles. Preferably a nanocrystal light emitting device further comprises at least one electron transport layer and/or at least one hole transport layer.

The at least one hole transport layer is formed from the material capable of transporting holes and the electron transport layer is formed from the material capable of transporting electrons. Suitable examples of hole transport materials to be used in the present invention are selected from the group consisting of poly(3,4-ethylenedioxythiophene)(PEDOT)/ polystyrene parasulfonate (PSS), poly(N-vinylcarbazole) derivatives, polyphenylenevinylene derivatives, polyparaphenylene derivatives, polymethacrylate derivatives, poly(9,9-octylfluorene) derivatives, poly(spiro-fluorene) derivatives, poly (3-hexylthiophene-2,5-diyl) derivatives, polyaniline derivatives and the like. Suitable examples of electron transport layers to be used in the present invention are selected from the group consisting of zinc oxide, titanium dioxide, oxazoles, isooxazoles, triazoles, isothiazoles, oxydiazoles, thiadiazoles, perylenes, and aluminum complexes, including tris(8-hydroxyquinoline)-aluminum (Alq₃).

Preferably, the emissive layer is located between the hole and electron transport layers if they are present in the nanocrystal light emitting device.

Optionally, the NC-LED may further comprise a hole injection layer, an electron injection layer, a hole blocking layer or an electron blocking layer. Specific examples of injection layers include, but are not limited to, Ca, Ba, Ca/AI, LiF/Ca, LiF/Al, Al, Mg, and Ag:Mg alloys. Specific examples of blocking layers include, but are not limited to, 3-phenyl-4-(1 -naphthyl)-5-phenyl- 1 ,2,4-triazole (TAZ), 2,9-dimethyl-4,7-diphenyl-1,10-phenanthroline (BCP), phenanthrolines, imidazoles, triazoles, oxadiazoles, and aluminum complexes.

The nanocrystal light emitting device according to the present invention can be prepared by using ordinary techniques described in the art. The different layers forming a NC-LEDs can be prepared using standard thin film deposition techniques. Some examples of fabrication techniques used are spin coating, ink-jet printing, screen printing, thermal evaporation, ion beam evaporation or sputtering among others.

The emissive film according to the present invention allows the fabrication of all solution processed NC-LEDs. The NCs in the emissive film according to the present invention are crosslinked between each other covalently, and therefore, they are not affected by the solvents used in the further fabrication steps in order to assemble the nanocrystal light emitting device.

### Examples

### Example 1

### Synthesis of functionalized CuInS/ZnS-TEMPIC NCs:

0.08 g of Cul, 0.4 g of In(OAc)₃ and 0.16 mL diphenylphosphine selenide (DPPSe) were added to 10 mL of Tris[2-(3-mercaptopropionyloxy)ethyl]isocyanurate (TEMPIC) in a three-neck flask equipped with a stirrer. The temperature was raised to 190°C for 10 minutes. Then, a mixture of 0.6 g of Zn(OAc)₂ and 5 ml of TEMPIC was added to the core solution and the mixture was further heated at 230 °C for 60 minutes. Afterwards, a mixture of 0.6 g of ZnSt₂ and 5 mL of TEMPIC was added to the core/shell solution and the mixture was heated for another 30 minutes at 230 °C. The solution was allowed to cool down to room temperature and centrifuged at 4500 rpm for 10 minutes. The CuInSeS/ZnS/ZnS NCs were then purified by three precipitation/dispersion cycles with the use of methanol and chloroform. Finally the purified material was dissolved in chloroform (200 mg/mL) and stored in the fridge. The photoluminescent quantum yield (PL-QY) of the solution was of 32.1% at 400 nm.

### Film formation:

The NC solution was filtered with 1.2 and 0.45 µm PTFE filters. Then, a 60 µl drop of the filtered solution was poured on a glass substrate and immediately spin-coated at 2000 RPM for 30 seconds. Consecutively, the film was annealed at 150°C for 40 minutes. A thin solid film of around 1 µm was formed. The photoluminescence quantum yield (PL-QY) of the film was of 31.1% at 400 nm.

### Example 2

### NC-LED device fabrication:

NC-LEDs were fabricated and encapsulated in a clean room (ISO 5 to 7). Pre-patterned ITO substrates (Ossila) were first sonicated in 10 wt.% solution of NaOH, and subsequently rinsed twice in deionized water. Afterwards, an oxygen plasma treatment was carried out in a *Tepla 300-E* from *Plasma Technics* at 500 W for 10 minutes. A poly(3,4-thylendioxythiophene)-poly(styrenesulfonate) (PEDOT:PSS) aqueous solution (*Heraeus CleviosTM P AI 4083*) was spin coated on the pre-patterned ITO substrate at 5000 RPM for 30 seconds and the film was kept on a hot plate at 150°C until the next layer was spin coated. The NC solution was filtered consecutively with a 1.2 and 0.45 µm PTFE filters.

Then, a 60 µL drop of the filtered solution was poured on the PEDOT:PSS layer and immediately spin-coated at 1000 RPM for 30 seconds. Consecutively, the film was crosslinked in an oven at 150°C for 20 minutes. Then, 60 µL of ZnO nanoparticles (BYK 3821) in isopropanol (30 mg/mL) were spin coated at 6000 RPM on top of the emissive film. After the spin coating, the stack was heated at 100°C during 10 minutes. 100 nm of extra pure (99.999%) aluminum were evaporated on top of the emissive layer at a rate of 1.35 Å/s at room temperature using a shadow mask. The NC-LEDs were then thermally annealed at 150°C for 15 min. The NC-LEDs were encapsulated with an optical silicone (Ls-6140) and a glass cover.

The I-V curve of the devices was characterized using a semiconductor parameter analyzer. Light was observed by eye at voltages above 20 V.

### Example 3:

### Synthesis of functionalized CuInS/ZnS-TEMPIC NCs

0.09 g of Cul and 0.6 g of In(OAc)₃ was dissolved in 40 millilitre of TEMPIC. The mixture was heated at 210°C for 5 minutes. A mixture of 0.6 g of ZnSt₂ and 10 ml of TEMPIC was added to the solution and the mixture was subsequently heated till 225 °C for 15 minutes. A red semiconductor colloidal NC solution (CuInS/ZnS-TEMPIC) was obtained. For purification, the solution was dispersed in an excess of chloroform, precipitated by methanol, centrifuged at 4000 rpm for 10 minutes and subsequently decanted. This cycle was repeated for three times. At last, the obtained NCs were redispersed in chloroform.

### NC-LED device fabrication

NC-LEDs were fabricated and encapsulated in a clean room (ISO 5 to 7). Pre-patterned ITO substrates (*Ossila*) were first sonicated in 10 wt.% solution of NaOH and then rinsed twice in deionized water. Afterwards, an oxygen plasma treatment was carried out in a *Tepla 300-E* from *Plasma Technics* at 500 W for 10 minutes. A poly(3,4-thylendioxythiophene)-poly(styrenesulfonate) (PEDOT:PSS) aqueous solution (*Heraeus CleviosTM P AI 4083*) was spin coated on the pre-patterned ITO substrate at 5000 RPM for 30 seconds and the film was kept on a hot plate at 150°C until the next layer was spin coated. The NC solution was filtered with 0.45 µm PTFE filters. Then, a 60 µl drop of the filtered solution was poured on the PEDOT:PSS layer and immediately spin-coated at 4000 RPM for 30 seconds. Consecutively, the film was crosslinked in an oven at 150°C for 20 minutes. The film was 20 nm thick. 100 nm of extra pure (99.999%) aluminum were evaporated on top of the emissive layer at a rate of 1.35 Å/s at room temperature using a shadow mask. The NC-LEDs were then thermally annealed at 150°C for 15 min. The NC-LEDs were encapsulated with an optical silicone (Ls-6140) and a glass cover.

The I-V curve of the devices was characterized using a semiconductor parameter analyzer. Light was observed by eye at voltages above 12 V.

### Example 4:

### Synthesis of functionalized CuInS/ZnS-KarenzMT™ PE1 NCs

0.05 g of Cul and 0.3 g of In(OAc)₃ were dissolved in 10 ml of KarenzMT™ PE1. The mixture was heated at 195°C for 10 minutes. A mixture of 5 g of ZnSt₂ and 10 ml of KarenzMT™ PE1 was added to the solution and the mixture was subsequently heated at 195 °C for 60 minutes. An orange semiconductor colloidal NC solution (CuInS/ZnS-KarenzMT™ PE1) is obtained. For purification, the solution was dispersed in an excess of chloroform, precipitated by methanol, centrifuged at 4000 rpm for 10 minutes and subsequently decanted. This cycle was repeated for three times. At last, the obtained NCs were redispersed in chloroform.

### NC-LED device fabrication

NC-LEDs were fabricated and encapsulated in a clean room (ISO 5 to 7). Pre-patterned ITO substrates (*Ossila*) were first sonicated in 10 wt.% solution of NaOH and then rinsed twice in deionized water. Afterwards, an oxygen plasma treatment was carried out in a *Tepla 300-E* from *Plasma Technics* at 500 W for 10 minutes. A poly(3,4-thylendioxythiophene)-poly(styrenesulfonate) (PEDOT:PSS) aqueous solution (*Heraeus CleviosTM P AI 4083*) was spin coated on the pre-patterned ITO substrate at 5000 RPM for 30 seconds and the film was kept on a hot plate at 150°C until the next layer was spin coated. The NC solution was filtered with 0.45 µm PTFE filters. Then, a 60 µl drop of the filtered solution was poured on the PEDOT:PSS layer and immediately spin-coated at 1000 RPM for 30 seconds. Consecutively, the film was crosslinked in an oven at 150°C for 30 minutes. The film was 20 nm thick. 100 nm of extra pure (99.999%) aluminum were evaporated on top of the emissive layer at a rate of 1.35 Å/s at room temperature using a shadow mask. The NC-LEDs were then thermally annealed at 150°C for 15 min. The NC-LEDs were encapsulated with an optical silicone (Ls-6140) and a glass cover.

The I-V curve of the devices was characterized using a semiconductor parameter analyzer. Light was observed by eye at voltages above 15 V.

### Example 5:

### Synthesis of functionalized Cu:ZnInS-KarenzMT™ PE1 NCs

0.01 g of Cul and 0.25 g of Zn(OAc)₂ and 0.2 g of In(OAc)₃ were dissolved in 10 ml of KarenzMT ™ PE1. The mixture was heated at 210 °C for 20 minutes. A yellow semiconductor colloidal NC solution (Cu:ZnlnS-KarenzMT ™ PE1) was obtained. At last, the obtained NCs were redispersed in chloroform.

### NC-LED device fabrication

NC-LEDs were fabricated and encapsulated in a clean room (ISO 5 to 7). Pre-patterned ITO substrates (*Ossila*) were first sonicated in 10 wt.% solution of NaOH and then rinsed twice in deionized water. Afterwards, an oxygen plasma treatment was carried out in a *Tepla 300-E* from *Plasma Technics* at 500 W for 10 minutes. A poly(3,4-thylendioxythiophene)-poly(styrenesulfonate) (PEDOT:PSS) aqueous solution (*Heraeus CleviosTM P AI 4083*) was spin coated on the pre-patterned ITO substrate at 5000 RPM for 30 seconds and the film was kept on a hot plate at 150°C until the next layer was spin coated. The NC solution was filtered with 0.45 µm PTFE filters. Then, a 60 µl drop of the filtered solution was poured on the PEDOT:PSS layer and immediately spin-coated at 1000 RPM for 30 seconds. Consecutively, the film was crosslinked in an oven at 150°C for 30 minutes. The film was 15 nm thick. 100 nm of extra pure (99.999%) aluminum were evaporated on top of the emissive layer at a rate of 1.35 Å/s at room temperature using a shadow mask. The NC-LEDs were then thermally annealed at 150°C for 15 min. The NC-LEDs were encapsulated with an optical silicone (Ls-6140) and a glass cover.

The I-V curve of the devices was characterized using a semiconductor parameter analyzer. Light was observed by eye at voltages above 7 V.

### Example 6

### NC-LED device fabrication

NC-LEDs were fabricated and encapsulated in a clean room (ISO 5 to 7). Pre-patterned ITO substrates (*Ossila*) were first sonicated in 10 wt.% solution of NaOH and then rinsed twice in deionized water. Subsequently, an oxygen plasma treatment was carried out in a *Tepla 300-E* from *Plasma Technics* at 500 W for 10 minutes. A poly(3,4-thylendioxythiophene)-poly(styrenesulfonate) (PEDOT:PSS) aqueous solution *(Heraeus CleviosTM P AI 4083)* was spin coated on the pre-patterned ITO substrate at 5000 RPM for 30 seconds, and the film was kept on a hot plate at 150°C until the next layer was spin coated. Poly(9-vinylcarbazole (*Sigma Aldrich 25.000-50.000 g*/*mol*) was dissolved in chlorobenzene (10 mg/ml) and was deposited on top of the PEDOT:PSS layer. A 60 µl drop was spin coated at 3000 RPM for 60 seconds. The film was subsequently annealed for 20 min at 150°C on a hot plate. The NC solution synthesized in example 1 was filtered with 0.45 µm PTFE filters. 60 µl drop of the filtered solution was poured on the poly(9-vinylcarbazole layer and immediately spin-coated at 1000 RPM for 60 seconds. Consecutively, the film was placed on a hot plate at 150°C for 10 minutes. 100 nm of extra pure (99.999%) aluminum were evaporated on top of the emissive layer at a rate of 1.35 Å/s at room temperature using a shadow mask. The NC-LEDs were then thermally annealed at 150°C for 15 min. The NC-LEDs were encapsulated with an optical silicone (*NuSil Ls-6140)* and a glass cover.

The I-V curve of the device was characterized using a semiconductor parameter analyzer. Light was observed by eye at voltages above 20 V.

### Example 7

### Synthesis of functionalized Cu:ZnInS-KarenzMT™ PE1 NCs

0.015 g of Cul and 0.20 g of In(OAc)₃ and 0.30 g of Zn(OAc)₂ were dissolved in 10 ml KarenzMT™ PE1. The mixture was heated at 215°C for 20 minutes. The mixture was allowed to cool down to room temperature. Yellowish reactive colloidal semiconductor NCs was obtained. Then, the NCs were dispersed in chloroform (10 mg/ml).

### NC-LED device fabrication

NC-LEDs were fabricated and encapsulated in a clean room (ISO 5 to 7). Pre-patterned ITO substrates (Ossila) were first sonicated in 10 wt.% solution of NaOH and then rinsed twice in deionized water. Subsequently, an oxygen plasma treatment was carried out in a *Tepla 300-E* from *Plasma Technics* at 500 W for 10 minutes. A poly(3,4-thylendioxythiophene)-poly(styrenesulfonate) (PEDOT:PSS) aqueous solution (*Heraeus CleviosTM P AI 4083*) was spin coated on the pre-patterned ITO substrate at 5000 RPM for 30 seconds and the film was kept on a hot plate at 150°C until the next layer was spin coated. The NC solution was filtered with 0.45 µm PTFE filters. Then, a 50 µl drop of the filtered solution was poured on the PEDOT:PSS layer and immediately spin-coated at 500 RPM for 60 seconds. Consecutively, the film was crosslinked in an oven at 150°C for 50 minutes. 100 nm of extra pure (99.999%) aluminum were evaporated on top of the emissive layer at a rate of 1.35 Å/s at room temperature using a shadow mask. The NC-LEDs were then thermally annealed at 150°C for 15 min. The NC-LEDs were encapsulated with an optical silicone (*NuSil Ls-6140*) and a glass cover.

The I-V curve of the devices was characterized using a semiconductor parameter analyzer. Light was observed by eye at voltages above 14 V.

### Example 8

### Synthesis of functionalized InP/ZnS--KarenzMT™ PE1 NCs

0.4 g of InCl₃, 0.24 g of ZnCl₂ were dissolved in 8 g Oleylamine. The mixture was heated at 220 °C for 10 minutes and 0.5 ml of tris(dimethylamino)phosphine was injected rapidly, after 4 minutes, 2.5 g KarenzMT™ PE1 was injected slowly. The reaction was stirred at 200°C for another 15 minutes. Reddish reactive colloidal semiconductor NCs (InP/ZnS-KarenzMT™ PE1) was obtained. Purification was performed multiple precipitation/dispersion cycles using methanol and chloroform. The obtained NCs were dissolved in chloroform.

### NC-LED device fabrication

NC-LEDs were fabricated and encapsulated in a clean room (ISO 5 to 7). Pre-patterned ITO substrates (Ossila) were first sonicated in 10 wt.% solution of NaOH and then rinsed twice in deionized water. Subsequently, an oxygen plasma treatment was carried out in a *Tepla 300-E* from *Plasma Technics* at 500 W for 10 minutes. A poly(3,4-thylendioxythiophene)-poly(styrenesulfonate) (PEDOT:PSS) aqueous solution (*Heraeus CleviosTM P AI 4083*) was spin coated on the pre-patterned ITO substrate at 5000 RPM for 30 seconds and the film was kept on a hot plate at 150 °C until the next layer was spin coated. The NC solution was filtered with 0.45 µm PTFE filters. Then, a 60 µl drop of the filtered solution was poured on the PEDOT:PSS layer and immediately spin-coated at 1000 RPM for 60 seconds. Consecutively, the film was crosslinked in an oven at 150 °C for 50 minutes. After the thermal treatment, the film was still showing a reddish emission when irradiated by UV light. 100 nm of extra pure (99.999%) aluminum were evaporated on top of the emissive layer at a rate of 1.35 Å/s at room temperature using a shadow mask. The NC-LEDs were then thermally annealed at 150 °C for 15 min. The NC-LEDs were encapsulated with an optical silicone (*NuSil Ls-6140*) and a glass cover.

The I-V curve of the devices was characterized using a semiconductor parameter analyzer. Light was observed by eye at voltages above 12 V.

### Example 9

### Ink-jet printed NC-LED device fabrication

NC-LEDs were fabricated and encapsulated in a clean room (ISO 5 to 7) unless otherwise specified. Pre-patterned ITO substrates (Ossila) were first sonicated in 10 wt.% solution of NaOH and then rinsed twice in deionized water. Afterwards, an oxygen plasma treatment was carried out in a *Tepla 300-E* from *Plasma Technics* at 500 W for 10 minutes. A poly(3,4-thylendioxythiophene)-poly(styrenesulfonate) (PEDOT:PSS) aqueous solution (*Heraeus CleviosTM P AI 4083*) was spin coated on the pre-patterned ITO substrate at 5000 RPM for 30 seconds and the film was kept on a hot plate at 150°C during 15 minutes.

In order to deposit the emissive film by ink-jet printing, the multifunctional NC solution synthesized in Example 4 was redisolved in chlorobenzene and 1,2-dichlorobenzene (1:2) at a concentration of 100 mg/ml. Subsequently NCs ink formulation was jetted by a printhead with a nozzle diameter of 21 µm (*Dimatix DMP-2831, DMC-11610*). A print resolution of 508 dpi lead to a thickness of about 25 nm. Consecutively, the film was crosslinked on a hot plate at 150 °C for 30 minutes.

100 nm of extra pure (99.999%) aluminum were evaporated on top of the emissive layer at a rate of 1.35 Å/s at room temperature using a shadow mask. Subsequently the NC-LEDs were thermally annealed at 150°C for 15 min. The NC-LEDs were encapsulated with an optical silicone (Ls-6140) and a glass cover.

The I-V curve of the devices was characterized using a semiconductor parameter analyzer. Light was observed by eye at voltages above 15 V.

## Claims

1. An emissive film comprising a network of crosslinked nanocrystals, wherein said network of crosslinked nanocrystals is formed from reactive colloidal nanocrystals comprising
a) a core comprising a semiconductive compound, wherein said semiconductive compound is a combination of elements selected from the group consisting of Zn, In, Cu, S and Se; and
b) at least one polythiol ligand selected from the group consisting of primary thiols, secondary thiols and mixtures thereof, and
wherein said core is surrounded by at least one polythiol ligand, wherein each core surrounded by at least one polythiol ligand is crosslinked with at least one another polythiol ligand surrounding another core, and wherein said nanocrystals do not undergo a ligand exchange process and only the original ligands present during the synthesis are attached.

2. An emissive film according to claim 1, wherein said network of crosslinked nanocrystals is formed via covalent bonds.

3. An emissive film according to claim 1 or 2, wherein said core comprising a semiconductive compound comprises a core and at least one monolayer or multilayer shell.

4. An emissive film according to claim 1 or 2, wherein said core comprising a semiconductive compound comprises a core and at least two monolayer and/or multilayer shells.

5. An emissive film according to any one of claims 1 to 4, wherein said core comprises a semiconductive compound comprising copper which is selected from the group consisting of CuInS, CuInSeS, CuZnInSeS, CuZnlnS, Cu:ZnlnS, CuInS/ZnS, Cu:ZnInS/ZnS, and CuInSeS/ZnS.

6. An emissive film according to claim 5, wherein said core comprises a semiconductive compound comprising copper which is selected from the group consisting of CuInS/ZnS, CuInSeS/ZnS, Cu:ZnInS/ZnS.

7. An emissive film according to any one of claims 1 to 6, wherein said polythiol ligand has functionality at least 2, preferably from 3 to 4.

8. An emissive film according to any one of claims 1 to 7, wherein said at least one polythiol ligand is selected from the group consisting of pentaerythritol tetrakis (3-mercaptobutylate), pentaerythritol tetra-3-mercaptopropionate, trimethylolpropane tri(3-mercaptopropionate), tris[2-(3-mercaptopropionyloxy)ethyl]isocyanurate, dipentaerythritol hexakis(3-mercaptopropionate), ethoxilated-trimethylolpropan tri-3-mercaptopropionate, mercapto functional methylalkyl silicone polymer and mixtures thereof, and more preferably said at least one polythiol ligand is tris[2-(3-mercaptopropionyloxy)ethyl]isocyanurate.

9. An emissive film according to any one of the claims 1 to 8, wherein said emissive film has a thickness from 2 nm to 2000 nm, preferably from 3 nm to 1000 nm, more preferably from 4 nm to 500 nm, even more preferably from 4 nm to 150 nm and most preferably from 5 nm to 45 nm.

10. A process to prepare an emissive film according to any one of claims 1 to 9 comprising steps of:
1) mixing a core comprising semiconductive compound and at least one polythiol ligand to form a reactive colloidal nanocrystal;
2) optionally adding at least one solvent into a product of step 1;
3) forming a film from the mixture of step 2; and
4) optionally thermal curing,
wherein nanocrystals formed in step 1) do not undergo a ligand exchange process.

11. A process to prepare an emissive film according to claim 10, wherein concentration of mixture of step 2 is from 1 mg of reactive colloidal nanocrystals in 1 ml of solvent to 200 mg of reactive colloidal nanocrystals in 1 ml of solvent.

12. A process to prepare an emissive film according to claim 10, wherein concentration of mixture of step 2 is from 3 mg of reactive colloidal nanocrystals in 1 ml of solvent to 50 mg of reactive colloidal nanocrystals in 1 ml of solvent.

13. A process to prepare an emissive film according to claim 10, wherein concentration of mixture of step 2 is from 5 mg of reactive colloidal nanocrystals in 1 ml of solvent to 30 mg of reactive colloidal nanocrystals in 1 ml of solvent.

14. A nanocrystal light emitting device comprising a multilayer structure comprising
a) an emissive film layer according to any one of claims 1 to 9;
b) a cathode layer; and
c) an anode layer.

15. A nanocrystal light emitting device according to claim 14, further comprising at least one electron transport layer and/or at least one hole transport layer.

## Patentansprüche

1. Emissionsschicht, umfassend ein Netzwerk vernetzter Nanokristalle, wobei das Netzwerk vernetzter Nanokristalle aus reaktiven kolloidalen Nanokristallen gebildet ist, umfassend
a) einen Kern, umfassend eine halbleitende Zusammensetzung, wobei die halbleitende Zusammensetzung eine Kombination von Elementen ist, ausgewählt aus der Gruppe, bestehend aus Zn, In, Cu, S und Se; und
b) mindestens einem Polythiol-Liganden, ausgewählt aus der Gruppe, bestehend aus primären Thiolen, sekundären Thiolen und Gemischen davon, und
wobei der Kern von mindestens einem Polythiol-Liganden umgeben ist, wobei jeder von mindestens einem Polythiol-Liganden umgebene Kern mit mindestens einem anderen Polythiol-Liganden vernetzt ist, der einen anderen Kern umgibt, und wobei die Nanokristalle keinem Ligandenaustauschvorgang unterzogen werden und nur die während der Synthese vorhandenen ursprünglichen Liganden gebunden werden.

2. Emissionsschicht nach Anspruch 1, wobei das Netzwerk vernetzter Nanokristalle über kovalente Bindungen gebildet wird.

3. Emissionsschicht nach Anspruch 1 oder 2, wobei der eine halbleitende Zusammensetzung umfassende Kern einen Kern und mindestens eine einlagige oder mehrlagige Hülle umfasst.

4. Emissionsschicht nach Anspruch 1 oder 2, wobei der eine halbleitende Zusammensetzung umfassende Kern einen Kern und mindestens zwei einlagige und/oder mehrlagige Hüllen umfasst.

5. Emissionsschicht nach einem beliebigen der Ansprüche 1 bis 4, wobei der Kern eine Kupfer umfassende halbleitende Zusammensetzung umfasst, die ausgewählt ist aus der Gruppe, bestehend aus CuInS, CuInSeS, CuZnInSeS, CuZnInS, Cu:ZnInS, CuInS/ZnS, Cu:ZnInS/ZnS und CuInSeS/ZnS.

6. Emissionsschicht nach Anspruch 5, wobei der Kern eine Kupfer umfassende halbleitende Zusammensetzung umfasst, die ausgewählt ist aus der Gruppe, bestehend aus CuInS/ZnS, CuInSeS/ZnS, Cu:ZnInS/ZnS.

7. Emissionsschicht nach einem beliebigen der Ansprüche 1 bis 6, wobei der Polythiol-Ligand eine Funktionalität von mindestens 2, vorzugsweise von 3 bis 4 aufweist.

8. Emissionsschicht nach einem beliebigen der Ansprüche 1 bis 7, wobei der mindestens eine Polythiol-Ligand ausgewählt ist aus der Gruppe, bestehend aus Pentaerythritoltetrakis (3-Mercaptobutylat), Pentaerythritol-Tetra-3-Mercaptopropionat, Trimethylolpropan-Tri(3-Mercaptopropionat), Tris[2-(3-Mercaptopropionyloxy)ethyl]isocyanurat, Dipentaerythritol-Hexakis(3-Mercaptopropionat), Ethoxiliert-Trimethylolpropan-Tri-3-Mercaptopropionat, mercapto-funktionelles Methylalkyl-Silikonpolymer und Gemische davon, und noch besser ist der mindestens eine Polythiol-Ligand Tris[2-(3-Mercaptopropionyloxy)ethyl]isocyanurat.

9. Emissionsschicht nach einem beliebigen der Ansprüche 1 bis 8, wobei die Emissionsschicht eine Dicke von 2 nm bis 2000 nm, vorzugsweise von 3 nm bis 1000 nm, bevorzugter von 4 nm bis 500 nm, noch bevorzugter von 4 nm bis 150 nm und am besten von 5 nm bis 45 nm aufweist.

10. Verfahren zum Erstellen einer Emissionsschicht nach einem beliebigen der Ansprüche 1 bis 9, umfassend die Schritte des:
1) Mischens eines Kerns, umfassend die halbleitende Zusammensetzung und mindestens einen Polythiol-Liganden, um einen reaktiven kolloidalen Nanokristall zu bilden;
2) wahlweisen Zugebens mindestens eines Lösungsmittels in ein Produkt von Schritt 1;
3) Ausbildens einer Schicht aus dem Gemisch von Schritt 2; und
4) wahlweisen thermischen Aushärtens;
wobei die in Schritt 1) gebildeten Nanokristalle keinem Ligandenaustauschvorgang unterzogen werden.

11. Verfahren zum Erstellen einer Emissionsschicht nach Anspruch 10, wobei die Konzentration des Gemischs von Schritt 2 1 mg reaktiver kolloidaler Nanokristalle in 1 ml Lösungsmittel bis 200 mg reaktiver kolloidaler Nanokristalle in 1 ml Lösungsmittel beträgt.

12. Verfahren zum Erstellen einer Emissionsschicht nach Anspruch 10, wobei die Konzentration des Gemischs von Schritt 2 3 mg reaktiver kolloidaler Nanokristalle in 1 ml Lösungsmittel bis 50 mg reaktiver kolloidaler Nanokristalle in 1 ml Lösungsmittel beträgt.

13. Verfahren zum Erstellen einer Emissionsschicht nach Anspruch 10, wobei die Konzentration des Gemischs von Schritt 2 5 mg reaktiver kolloidaler Nanokristalle in 1 ml Lösungsmittel bis 30 mg reaktiver kolloidaler Nanokristalle in 1 ml Lösungsmittel beträgt.

14. Licht emittierende Vorrichtung aus Nanokristallen, umfassend einen mehrschichtigen Aufbau, umfassend
a) eine Emissionsschicht nach einem beliebigen der Ansprüche 1 bis 9;
b) eine Kathodenschicht; und
c) eine Anodenschicht.

15. Licht emittierende Vorrichtung aus Nanokristallen nach Anspruch 14, weiter umfassend mindestens eine Elektronentransportschicht und/oder mindestens eine Löcher-Transportschicht.

## Revendications

1. Film émissif comprenant un réseau de nanocristaux réticulés, dans lequel ledit réseau de nanocristaux réticulés est formé à partir de nanocristaux colloïdaux réactifs comprenant
a) un noyau comprenant un composé semi-conducteur, dans lequel ledit composé semi-conducteur est une combinaison d'éléments sélectionnés dans le groupe constitué par Zn, In, Cu, S et Se ; et
b) au moins un ligand polythiol sélectionné dans le groupe constitué par les thiols primaires, les thiols secondaires et les mélanges de ces derniers, et
dans lequel ledit noyau est entouré par au moins un ligand polythiol, dans lequel chaque noyau entouré par au moins un ligand polythiol est réticulé avec au moins un autre ligand polythiol entourant un autre noyau, et dans lequel lesdits nanocristaux ne subissent pas de processus d'échange de ligands et seuls les ligands initiaux présents pendant la synthèse sont fixés.

2. Film émissif selon la revendication 1, dans lequel ledit réseau de nanocristaux réticulés est formé via des liaisons covalentes.

3. Film émissif selon la revendication 1 ou 2, dans lequel ledit noyau comprenant un composé semi-conducteur comprend un noyau et au moins une enveloppe monocouche ou multicouche.

4. Film émissif selon la revendication 1 ou 2, dans lequel ledit noyau comprenant un composé semi-conducteur comprend un noyau et au moins deux enveloppes monocouches et/ou multicouches.

5. Film émissif selon l'une quelconque des revendications 1 à 4, dans lequel ledit noyau comprend un composé semi-conducteur comprenant du cuivre qui est sélectionné dans le groupe constitué par CuInS, CuInSeS, CuZnInSeS, CuZnInS, Cu:ZnInS, CuInS/ZnS, Cu:ZnInS/ZnS et CuInSeS/ZnS.

6. Film émissif selon la revendication 5, dans lequel ledit noyau comprend un composé semi-conducteur comprenant du cuivre qui est sélectionné dans le groupe constitué par CulnS/ZnS, CulnSeS/ZnS, Cu:ZnInS/ZnS.

7. Film émissif selon l'une quelconque des revendications 1 à 6, dans lequel ledit ligand polythiol a une fonctionnalité d'au moins 2, de préférence de 3 à 4.

8. Film émissif selon l'une quelconque des revendications 1 à 7, dans lequel ledit au moins un ligand polythiol est sélectionné dans le groupe constitué par le tétrakis (3-mercaptobutylate) de pentaérythritol, le tétra-3-mercaptopropionate de pentaérythritol, le tri(3-mercaptopropionate) de triméthylolpropane, l'isocyanurate de tris[2-(3-mercaptopropionyloxy)éthyle], hexakis(3-mercaptopropionate) de dipentaérythritol, le tri-3-mercaptopropionate de triméthylolpropane éthoxylé, un polymère de méthylalkyl-silicone à fonction mercapto et des mélanges de ces derniers, et, plus préférablement, ledit au moins un ligand polythiol est l'isocyanurate de tris[2-(3-mercaptopropionyloxy)éthyle].

9. Film émissif selon l'une quelconque des revendications 1 à 8, dans lequel ledit film émissif a une épaisseur de 2 nm à 2 000 nm, de préférence de 3 nm à 1 000 nm, plus préférablement de 4 nm à 500 nm, de manière encore plus préférée de 4 nm à 150 nm et de manière la plus préférée de 5 nm à 45 nm.

10. Procédé pour préparer un film émissif selon l'une quelconque des revendications 1 à 9, comprenant les étapes consistant à :
1) mélanger un noyau comprenant un composé semi-conducteur et au moins un ligand polythiol pour former un nanocristal colloïdal réactif ;
2) ajouter facultativement au moins un solvant à un produit de l'étape 1 ;
3) former un film à partir du mélange de l'étape 2 ; et
4) durcissement thermique facultatif,
dans lequel les nanocristaux formés à l'étape 1 ne subissent pas de processus d'échange de ligands.

11. Procédé pour préparer un film émissif selon la revendication 10, dans lequel la concentration du mélange de l'étape 2 est de 1 mg de nanocristaux colloïdaux réactifs dans 1 ml de solvant à 200 mg de nanocristaux colloïdaux réactifs dans 1 ml de solvant.

12. Procédé pour préparer un film émissif selon la revendication 10, dans lequel la concentration du mélange de l'étape 2 est de 3 mg de nanocristaux colloïdaux réactifs dans 1 ml de solvant à 50 mg de nanocristaux colloïdaux réactifs dans 1 ml de solvant.

13. Procédé pour préparer un film émissif selon la revendication 10, dans lequel la concentration du mélange de l'étape 2 est de 5 mg de nanocristaux colloïdaux réactifs dans 1 ml de solvant à 30 mg de nanocristaux colloïdaux réactifs dans 1 ml de solvant.

14. Dispositif électroluminescent à nanocristaux comprenant une structure multicouche comprenant
a) une couche de film émissif selon l'une quelconque des revendications 1 à 9 ;
b) une couche de cathode ; et
c) une couche d'anode.

15. Dispositif électroluminescent à nanocristaux selon la revendication 14, comprenant en outre au moins une couche de transport d'électrons et/ou au moins une couche de transport de trous.
